(19) Europäisches Patentamt
European Patent Office
Office européen des brevets

(11) **EP 4 420 153 B1**

(12) **EUROPEAN PATENT SPECIFICATION**

(45) Date of publication and mention
of the grant of the patent:
**13.08.2025  Bulletin 2025/33**

(21) Application number: **22801786.9**

(22) Date of filing: **13.10.2022**

(51) International Patent Classification (IPC):
*H01L 21/265* $^{(2006.01)}$   *H01L 21/268* $^{(2006.01)}$
*H10D 8/01* $^{(2025.01)}$   *H10D 8/60* $^{(2025.01)}$
*H10D 12/01* $^{(2025.01)}$   *H10D 30/66* $^{(2025.01)}$
*H10D 62/10* $^{(2025.01)}$   *H10D 62/832* $^{(2025.01)}$

(52) Cooperative Patent Classification (CPC):
H01L 21/268; H01L 21/046; H01L 21/0485;
H10D 8/051; H10D 8/60; H10D 30/0291;
H10D 30/66; H10D 30/665; H10D 62/105;
H10D 62/106; H10D 62/8325

(86) International application number:
**PCT/EP2022/078546**

(87) International publication number:
**WO 2023/066788 (27.04.2023 Gazette 2023/17)**

(54) **COATING-ASSISTED LASER ANNEALING PROCESS FOR THE MANUFACTURING OF WIDE-BANDGAP SEMICONDUCTOR DEVICES**

LASERGLÜHVERFAHREN MIT BESCHICHTUNGSUNTERSTÜTZUNG ZUR HERSTELLUNG VON HALBLEITERVORRICHTUNGEN MIT GROSSER BANDLÜCKE

PROCÉDÉ DE RECUIT AU LASER ASSISTÉ PAR REVÊTEMENT POUR LA FABRICATION DE DISPOSITIFS SEMI-CONDUCTEURS À LARGE BANDE INTERDITE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority:  **18.10.2021  IT 202100026678**

(43) Date of publication of application:
**28.08.2024  Bulletin 2024/35**

(73) Proprietor: **Consiglio Nazionale Delle Ricerche
00185 Roma (IT)**

(72) Inventors:
• **CALABRETTA, Cristiano
  00185 ROMA (IT)**
• **LA VIA, Francesco
  00185 ROMA (IT)**
• **PECORA, Alessandro
  00185 ROMA (IT)**

(74) Representative: **Maccalli, Marco et al
Maccalli & Pezzoli S.r.l.
Via Settembrini, 40
20124 Milano (IT)**

(56) References cited:
**JP-A- 2012 069 748    US-A1- 2008 108 210**

**EP 4 420 153 B1**

**Description**

<u>Background</u>

<u>Technical field</u>

The solution disclosed in the present document relates broadly to the field of electronics, particularly to the field of semiconductor technology.

<u>Overview of the relevant art</u>

The use of innovative materials (compared to conventional silicon) for the construction of electronic devices for certain applications like power devices, particularly wide energy bandgap semiconductors (Wide-Bandgap semiconductors, also known as WBG semiconductors or WBGSs, which are semiconductor materials having a relatively large bandgap compared to conventional semiconductors like silicon) such as silicon carbide - SiC - and gallium nitride - GaN -, would bring about several advantages.

Electronic devices based on wide energy gap semiconductors, having energy gaps greater than 2 eV (compared to 1.12 eV of silicon - Si) are more efficient and are characterized by their small power losses. In particular, the interest in SiC is currently increasing due to high breakdown electric field, radiation hardness and thermal conductivity, in addition to its advantageously wide bandgap. Unipolar field effect transistors based on metal-oxide-semiconductor contacts (the known Metal Oxide Semiconductor Field Effect Transistors or MOSFETs) made of SiC are considered the ideal kind of electronic device and the most efficient way to overcome the drawbacks of actual electronic devices used in the context of power electronics, namely Insulated Gate Bipolar Transistors (IGBTs), manufactured in Si. This would allow to have power electronic devices operating up to 3,000 V with a specific on-state resistance similar to that of MOSFETs in Si operating at 300 V, a very attractive feature in applications requiring high switching speed and low switching losses.

Ion implantation is a key processing technology in the fabrication of almost all kinds of semiconductor devices, including SiC based devices. Ion implantation is the (more common) way semiconductor materials are doped with dopant species (e.g., boron, phosphorus, arsenic) to modify the electrical conductivity of the semiconductor material, obtaining $n$ conductivity type and $p$ conductivity type semiconductor material regions.

However, the common drawback of ion implantation is the generation of lattice disorder in the lattice of the semiconductor material. Typically, post-implantation annealing at high temperature (T > 1600 °C) is used to electrically activate the implanted dopant species and to recover the defectiveness of the ion implanted area. During this thermal treatment, the semiconductor material lattice (e.g., the lattice of 4H-SiC, which is the $\alpha$ polytype of the SiC, having a hexagonal crystal structure, more frequently used) which has been damaged by the ion implantation process is recovered and a part of the implanted atoms is allocated to substitutional lattice sites. Thermal equilibrium extracted solid solubility plays a significant role in defining the upper limits of the activated dopant concentration for specific annealing temperature. It is experimentally proven that the electrical activation efficiency improves with increasing annealing temperature.

Conventional furnace annealing processes do not allow the achievement of temperatures suitable (i.e., sufficiently high) for effective full dopant species activation, especially in case of high implant concentrations. Furthermore, these annealing techniques are responsible of the generation of a high concentration of point defects and their aggregates in the implanted area.

Annealing temperature processes between 1600 °C and 1700 °C for times ranging from 30 minutes to 1 hour, i.e., with long time - thermal budget, result in the generation of a high concentration of defectiveness throughout the wafer of semiconductor material. The main category of defects is represented by point defects. Point defects in a SiC material include silicon vacancies ($V_{Si}$) and carbon vacancies ($V_C$). Both $V_{Si}$ and $V_C$ are electrically active with several electron states in the bandgap which promote charge carrier recombination. For instance, this is the original source of the so-called $Z_{1/2}$ (EC-0.63 eV), $EH_{6/7}$ (EC-1.55 eV) and $HK_4$ ($E_V$+1.45 eV) deep levels commonly observed in implanted and annealed 4H-SiC epitaxial layers.

New dislocations are guided by misfit and thermal stress, becoming the driving force for dislocation nucleation or glide motion. The prolonged permanence at high temperatures, therefore, induces the onset of additional stress phenomena, giving rise to the generation of new dislocations and the movement of already existing ones. The density of generated point defects is so high that they often segregate inside the implanted region during annealing, leading to the formation of extended defects, such as dislocation loops and stacking faults. The area inside the implant is affected by an extended defectivity network characterized by loops traces in the {-12-13} and {-24-23} plane families.

Defects limiting the lifetime of charge carriers and their concentration need to be controlled/minimized. After experimental investigations it was found that lower thermal equilibrium carbon vacancy concentration $[V_c]_{eq}$ were revealed after annealing treatments at 1500 °C for long times. This approach is based on the concept of injecting carbon interstitials $C_i$ from the surface leading to subsequent recombination with $V_c$. Although these tests have led to a gradual reduction in $V_c$

concentration, it has been noted that $V_c$ annihilation process goes to saturation with time resulting in SiC intra-bandgap photoluminescence emission reduction of just about 20%.

Microwave annealing processes allow reaching 2000 °C process temperature, however, although they involve short ( ~30 seconds) annealing times, from the data known up to now, the $V_c$ concentration is comparable to that coming from conventional high temperature annealing.

Laser annealing techniques allow attaining higher temperatures than conventional thermal processes, with consequent maximization of the active doping concentration and lower defectiveness.

Actually, poor control has so far been obtained on laser induced surface etching and active oxidation phenomena which cause an increase in surface roughness. Moreover, careful laser energy density calculations must be carried out taking into account the variation of refractive index and absorption coefficient related to implant dose and it is difficult to vary the laser parameters following the degree of the sample crystalline recovery during the annealing treatment.

US 2019341261 A1 discloses an enhanced symmetric multicycle rapid thermal annealing process for removing defects and activating implanted dopant impurities in a III-nitride semiconductor sample. A sample is placed in an enclosure and heated to a temperature T1 under an applied pressure P1 for a time t1. While the heating of the sample is maintained, the sample is subjected to a series of rapid laser irradiations under an applied pressure P2 and a baseline temperature T2. Each of the laser irradiations heats the sample to a temperature Tmax above its thermodynamic stability limit. After a predetermined number of temperature pulses or a predetermined period of time, the laser irradiations are stopped and the sample is brought to a temperature T3 and held at T3 for a time t3 to complete the annealing. A rapid heating and cooling of the sample is produced by laser irradiation, which allows for very rapid heating and cooling since the heat generated by the laser is localized near the surface and is rapidly dissipated into the bulk of the material. The sample can include a laser beam susceptor, i.e., a material that can be heated by absorbing a laser light, deposited on the target film, e.g., a layer of tungsten (W) deposited on an AlN film deposited on a GaN layer deposited on a SiC substrate. The laser power can be absorbed in the laser susceptor layer.

JP 2012069748 discloses that an object to be annealed including a SiC layer and an absorption layer formed on the SiC layer is prepared. The absorption layer of the object to be annealed is irradiated with a laser beam, and the energy of the laser beam absorbed into the absorption layer causes the absorption layer to generate heat. The SiC layer is heated by the heat generated in the absorption layer. A carbon film having a graphite structure is formed on the surface of the SiC substrate to which Al is added. A silicon film is formed on the surface of the carbon film. A pulse laser beam is irradiated on the silicon film of the substrate. The heat generated by the silicon film and the carbon film is transferred to the SiC substrate and raises the temperature of the SiC substrate. The silicon film prevents the carbon film from being oxidized and consumed.

Summary of the disclosed solution

The Applicant has found that, in a laser annealing process of a semiconductor structure (particularly, a structure in a wide-bandgap semiconductor material, e.g., a SiC structure), the use of a layer of suitable thickness of a heat absorbing material, and featuring suitable values of optical extinction coefficient k and reflectance, formed, e.g., deposited on the surface of the semiconductor structure to be annealed is able to totally absorb the laser radiation and to diffuse the heat on the underlying layers of the semiconductor structure during laser annealing. As known, the optical extinction coefficient of a material characterizes how easily it can be penetrated by a beam of light. The reflectance of (the surface of) a material is an index of the effectiveness in reflecting radiant energy, i.e., it is the fraction of incident electromagnetic power that is reflected.

Particularly, suitable values of optical extinction coefficient k are values equal to approximately 0.2 or greater, and suitable values of reflectance are values less than approximately 5%.

The layer of heat absorbing material can be a layer of amorphous carbon or graphite. Other possible materials for the layer of heat absorbing material can be Tantalum carbide (TaC) or Hafnium carbide (HfC). Other suitable materials for the layer of heat absorbing material are Zirconium carbide (ZrC) and Hafnium carbide (HfC). Still suitable, although less preferred, materials are Tantalum diboride ($TaB_2$), Zirconium diboride ($ZrB_2$), Hafnium diboride ($HfB_2$).

This laser annealing process allows to achieve rapid high temperature thermal treatments suitable for dopant activation and implantation-induced damage recovery preventing the usual surface degradation of the semiconductor structure.

For example, the Applicant has found that the use of an amorphous carbon or graphite layer of less than 500 nm thickness formed on the semiconductor structure surface allows performing a laser annealing on large regions or on selected areas of the semiconductor structure, preserving the semiconductor structure surface (e.g., the SiC surface) from damaging. Amorphous carbon and graphite are characterized by high absorption coefficient and negligible reflectivity so that, by absorbing laser radiation, these materials are able to reach high temperatures and to heat the underlying SiC layers, particularly those regions of the SiC material that have been implanted with dopant species. This strategy allows preserving the semiconductor structure surface from etching phenomena and to perform laser annealing processes without taking into account implanted SiC optical parameters.

As will be explained in greater detail in the following, during the first stages of the laser annealing process the layer of heat absorbing material substantially shields the underlying semiconductor structure from the laser radiation and an initial recovery of the optical parameters of the implanted semiconductor crystal is achieved, in the absence of the laser radiation optical contact with the underlying semiconductor structure (or, at least, with a weak interaction of the laser radiation with the underlying semiconductor).

The Applicant has found that the progressive erosion of the layer of heat absorbing material, e.g., the layer of amorphous carbon or graphite, when exposed to laser radiation is useful to slowly recover the optical parameters of the implanted SiC. As a result, this method permits to make the progressive optical penetration of the laser radiation inside the SiC layer tolerated by the surface layers of the semiconductor structure.

The Applicant observes that US 2019341261 A1 provides the possibility of superimposing susceptor stratification on which to perform laser irradiation processes. The document exemplifies a layering of a AlN layer superimposed to a GaN layer superimposed to a SiC substrate with a further layer of Tungsten (W) superimposed as an absorber layer of all previously mentioned system. The technique, however, is of dubious effectiveness, as the $CO_2$ and XeCl laser radiations used to perform laser annealing on the GaN layer and in the underlying SiC layer, respectively, are widely reflected by the W layer, affecting their effectiveness especially in heating both GaN layer and SiC substrate. The multitude of overlapping layers hinders the effectiveness of heat propagation between the different materials. Moreover, US 2019341261 A1 does not take into account the formation of the Tungsten oxide layers that could form on susceptor surface layer, affecting the effectiveness of heat conduction. The Applicant has observed, on the other hand, that a heat absorbing material layer made of any material selected from amorphous carbon or graphite, TaC, HfC, ZrC, HfC, TaB2, ZrB2, or HfB2 is a more effective absorber layer in the absorption and diffusion of heat thanks to the high absorption coefficients, higher melting temperature and high thermal conductivity.

The Applicant observes that JP 2012069748 consists of a laser annealing system relying on a carbon absorber layer having a thickness of not less than 2 times and less than 4 times the penetration length of the laser beam irradiated on the absorption layer. Consequently, optical penetration of the laser radiation into the semiconductor to be annealed is prevented. JP 2012069748 also considers the erosion of the absorption layer as an undesirable side effect to be avoided during the laser irradiation process. To avoid the erosion of the absorption layer an amorphous Si layer is thus deposited. The annealing process is thus carried out by the laser irradiation of the superimposed Si layer. The Applicant has found that such a technique is reasonably weak and of dubious effectiveness. In fact, the heat conduction process through a Si layer would induce the formation of a Si liquid phase in contact with the underlying carbon absorption layer, leading to two possible reactions: 1) on the one hand it produces an insufficient thermal treatment to achieve effective implanted dopants activation (graphite heating suffers from lack of optical penetration within graphite itself, as the laser only penetrates inside the Si layer), and 2) on the other hand, if irradiated at high energies to increase the fraction of activated dopant inside the implanted region, this technique can lead to nucleation of new surface amorphous SiC and to its adhesion on SiC surface with C fraction arising from the underlying graphitic layer. Furthermore, JP 2012069748 excludes the use of laser radiations with wavelengths above the bandgap of the semiconductor to be annealed.

Contrary to the teachings of JP 2012069748, the Applicant has found that the erosion of the heat absorber layer, instead of being an undesired side effect to be avoided, is advantageous for the annealing of implanted semiconductor regions.

The Applicant has found that the progressive erosion of the heat absorber layer when exposed to laser radiation makes it possible to obtain an annealing process in two phases. In a first annealing phase, when the implanted semiconductor regions are still affected by defectiveness due to the damages caused by dopant species implantation and their optical reflectivity is high, the laser radiation is substantially absorbed by the heat absorber layer and the annealing takes place essentially by transfer of heat from the heat absorber layer to the surface of the semiconductor to be annealed. In this way, a first recovery of the semiconductor crystal from the damages caused by the implanted species is achieved and the optical properties of the semiconductor are also recovered, the optical absorption coefficient being lowered.

Then, by progressive erosion of the heat absorber layer (possibly till its complete ablation from the surface of the semiconductor to be annealed), the laser radiation starts reaching and entering into contact with the semiconductor to be annealed. Both optical penetration of the laser radiation transmitted through the remaining heat absorber layer and heat conduction from the heat absorber layer contribute to the heating of the WBG semiconductor (e.g., SiC) structure to be annealed. At this stage, the semiconductor structure to be annealed exhibits an optical absorption coefficient intermediate between that of just after the implantation of dopants and that of a crystalline semiconductor and, in such a way, the semiconductor is able to tolerate higher energy densities. This combination of effects induces a more effective annealing than in the phase of exclusive heat transmission.

Deeper implanted regions of the semiconductor can thus be annealed compared to exclusive heat transmission from the absorber layer.

According to an aspect, the solution disclosed in this document provides a method of fabricating an electronic device, the method comprising:

- providing a layer of a wide-bandgap semiconductor material having a conductivity type;
- implanting dopant species in selected regions of said layer of a wide-bandgap semiconductor material to form implanted regions of said layer of a wide-bandgap semiconductor material, said implanted regions having an altered conductivity type with respect to the conductivity type of the layer of a wide-bandgap semiconductor material, and
- annealing the implanted regions of the layer of a wide-bandgap semiconductor material.

Said annealing comprises:

- coating said implanted regions to be annealed with a heat absorbing material layer, the heat absorbing material layer having an initial thickness, the material of the heat absorbing material layer having an optical extinction coefficient k equal to 0.2 or greater and a reflectance less than 5%, and
- exposing the heat absorbing material layer to a laser radiation having an energy density, to anneal the selected regions of the layer of a wide-bandgap semiconductor material.

The energy density of the laser radiation is selected in dependence of a dose of dopants of said implanted regions.

The initial thickness of the heat absorbing material layer is selected based on the energy density of the laser radiation so as to be sufficient to prevent the laser radiation to reach a surface of the underlying implanted regions to be annealed.

Said exposing the heat absorbing material layer to a laser radiation lasts for an exposure time and, during said exposure time, the heat absorbing material layer is subjected to erosion, so that during the exposure time the erosion of the heat absorbing material layer progressively allows at least part of the laser radiation to reach the surface of the underlying implanted regions to be annealed.

In embodiments, the heat absorbing material layer may be a layer of a material selected from:

amorphous carbon;
graphite;
Tantalum Carbide, TaC;
Hafnium Carbide, HfC;
Tantalum diboride, $TaB_2$;
Zirconium Carbide, ZrC;
Zirconium diboride, $ZrB_2$;
Hafnium diboride, $HfB_2$.

In embodiments, the heat absorbing material layer may be a layer of polycrystalline graphite. Polycrystalline graphite has a considerably higher thermal conductivity along the c crystal axis than crystalline graphite. This makes it favorable in the use of systems that provide the transmission of heat from a monochromatic radiative source.

The heat absorbing material layer may have a melting temperature higher than a melting temperature of the wide-bandgap semiconductor material.

In particular, albeit not limitatively, the wide-bandgap semiconductor material is SiC.

In exemplary embodiments, said laser radiation is a radiation emitted by an XeCl laser source at shots/point $\geq$ 1000, said heat absorbing material layer is a layer of graphite, and a residual thickness $G_{th}$ of the heat absorbing material layer depends on said initial thickness, $T_i$, and on said energy density of the laser radiation, $E_d$, according to the equation:

$$G_{th} = T_i - (287.7 \cdot {}^* E_d)$$

The laser energy of the laser radiation may be either greater than a bandgap of the wide-bandgap semiconductor material, e.g., ultraviolet, or lower than/equal to the bandgap of the wide-bandgap semiconductor material, e.g., visible and infrared.

In exemplary embodiments, for the annealing of a heavy implant of the order of $10^{18}$ cm$^{-3}$ or greater said initial thickness of the heat absorbing material layer is of about 270 nm or greater, while for the annealing of a light implant with a dopant concentration up to an order of $10^{17}$ cm$^{-3}$ said heat absorbing material layer is less than 270 nm.

According to another aspect, the solution disclosed in this document provides a semiconductor device comprising a layer of a wide-bandgap semiconductor material with selected regions thereof doped with dopants altering a conductivity type of the layer of a wide-bandgap semiconductor material, wherein the semiconductor device is fabricated by means of a method according to any one of the preceding claims.

In exemplary embodiments, the wide-bandgap semiconductor material is SiC.

The regions of the layer of a wide-bandgap semiconductor material doped with dopants may have small depths as well as depths greater than 1$\mu$m.

In exemplary embodiments, the semiconductor device may comprise a MOSFET, particularly a power MOSFET, and the regions of the layer of a wide-bandgap semiconductor material doped with dopants may include body regions and source regions of the power MOSFET.

Still by way of example, the semiconductor device may comprise a Junction-Barrier controlled Schottky diode and the regions of the layer of a wide-bandgap semiconductor material doped with dopants may include anode regions and Junction Termination Edge regions of the Junction-Barrier controlled Schottky diode.

During a first step of the laser annealing process, a gradual recovery of the optical and thermodinamic parameters of the implanted semiconductor region is achieved by means of heat diffusion from the heat absorber coating layer. The heat absorber coating layer is progressively eroded as the exposure to the laser radiation goes on, until, due to the thinning of the heat absorber coating layers, optical contact with the laser radiation is tolerated by the implanted semiconductor regions and annealing can be carried out to deeper implanted regions.

The coating of heat absorbing material layer made of any material selected from amorphous carbon, graphite, TaC, HfC, ZrC, HfC, TaB2, ZrB2, or HfB2 is able to absorb laser radiation in a few tens of nm and to heat the underlying layer of WBG semiconductor (e.g., SiC) in which dopant species have been implanted.

Usually, to carry out laser annealing on superficial implanted layers almost 1 $\mu$m thick, such as the source and body implants in SiC power MOSFET devices, UV laser wavelengths are exploited to achieve penetration lengths comparable with the implant depth. Nd:Yag (355 nm) and excimer lasers sources such as ArF (193 nm) and XeCl (308 nm), whose energy density must be triggered following the degree of amorphization and the implant dose, are used.

Thanks to the provision of the coating layer of heat absorbing material formed on the semiconductor structure to be annealed, it is possible to perform pulsed or continuous laser annealing on the semiconductor structure and extremely fast treatments at higher temperatures than conventional processes, with heat and cooling ramps as steep as $10^9$ °K/s. This temperature regime plays a fundamental role in electrical activation of the implanted dopants as it leads the enhancement of dopant solid solubility limit and therefore allows a greater concentration of activated dopant with respect to conventional furnace annealing processes.

Laser quick cooling ramps are also able to avoid doping deactivation effects and to prevent thermal generation of point defects. Through the irradiations on the coating of heat absorbing material layer it is possible to carry out the laser annealing process without taking into account the strong variation of the WBG semiconductor (e.g., SiC) optical parameters during the recovery of crystallinity after ion implantation. As an example, usually extracted values of extinction coefficient k show a variation from k = 1.0 for an amorphous 4H-SiC to k=1.3 · $10^{-2}$ for crystalline 4H-SiC at 308 nm. This behavior involves laser optical penetration length changes from few tens of nm to some $\mu$m. Furthermore, it is also necessary to take into account the transient variation of SiC absorption coefficient during a single irradiation, which varies by one order of magnitude from room temperature to 2000 °C. Moreover, since SiC (0001) has a relatively high surface energy, significant migration of surface atoms occurs at high temperature and results in formation of microsteps to minimize the total surface energy during laser-SiC interaction. The application of a coating of heat absorbing material layer prevents these issues as, e.g., polycrystalline graphite maintains constant refractive index and absorption coefficient with temperature increase so that laser irradiations are maintained isochronic.

For example, when the coating layer of heat absorbing material is a layer of graphite, the laser annealing process benefits from the 3800 °C graphite layer melting temperature and a conspicuous thermal budget can be transferred to the underlying the WBG semiconductor (e.g., SiC) structure through the high graphite thermal conductivity (~90 W/mK) in order to allow the annealing process. In this way, the achieved annealing temperature can exceed the one allowed in conventional activation furnaces and thus high dopant implant concentrations can be fully activated.

The irradiation of the coating layer of heat absorbing material also prevents the step bunching phenomenon and the formation of aggregates produced by the interaction of the semiconductor with residual oxygen in the chamber, which would give rise to $SiO_2$ aggregates in the early stages of laser annealing process. Indeed, it has been experimentally demonstrated that a SiC laser annealed surface coated by a graphite layer appears smooth and preserved from damage.

Once the treatment is completed, the remaining (if any) coating layer of heat absorbing material can be removed, for example through room temperature oxygen plasma cleaning.

The solution disclosed in the present document, providing for a laser annealing of semiconductor material regions implanted with dopants, particularly implanted regions of a wide-bandgap semiconductor material such as SiC regions, assisted by a heat-absorber coating layer of suitable thickness and featuring suitable values of optical extinction coefficient *k* and reflectance, for the electrical activation of the dopant ions, like for example an amorphous carbon or graphite coating layer assisted laser annealing, has therefore several advantages.

One advantage is the full activation of the implanted dopants by reaching higher process temperatures than those achievable in conventional furnace annealing processes.

Another advantage is the heat diffusion through the heat-absorber coating layer to keep intact the semiconductor surface and to avoid step bunching, oxidation and etching phenomena which usually afflict the SiC surfaces subjected to laser annealing.

The solution disclosed in the present document is also amenable to the adoption of laser energies below the semiconductor material (e.g., SiC) bandgap. Similarly to UV lasers, laser radiation energies below SiC bandgap would be absorbed by the overlying heat-absorber (e.g., graphitic or amorphous carbon) coating layer, leading to the same heat conduction mechanism towards the underlying WBG semiconductor (e.g., SiC) structure. As a consequence of the progressive thinning by erosion of the heat-absorber coating layer, the underlying WBG semiconductor (e.g., SiC) structure is exposed to optical contact with laser radiation and annealing due to optical absorption in SiC is added to heat propagation from the overlying heat-absorber coating layer. The optical absorption mechanism of laser source energies below the bandgap exploits the presence of implantation defects. Indeed, such defects include carbon and silicon vacancies, interstitials, Frenkel pairs, dopant impurities, etc., which introduce energy levels into SiC bandgap. Laser radiation with energy below the bandgap would, therefore, be able to promote electrons from the valence band to the intra-bandgap energy levels. The subsequent de-excitation from the intrabandgap levels introduced by the defects is promoted by electron-phonon (lattice vibrations) interactions and transfers the energy from the electrons to the lattice in timescales of the order of picoseconds and allows to heat the sample selectively within the implant region and to reach a consequent annealing effect on the semiconductor structure. In this way the extension of the technique to laser energies below the bandgap is granted and it is possible to achieve laser annealing process using visible and infrared wavelength laser sources.

A further advantage is the isochronicity of the laser annealing obtained since, unlike the WBG semiconductor (e.g., SiC) material, the refractive index and absorption coefficient of the heat absorption coating layer do not vary with temperature increase.

A still further advantage is the lower $V_c$ and extended defects concentration in the implanted and epitaxial layer of the semiconductor, leading to the enhancement of average carrier lifetime and mobility with respect to conventional annealing treatments.

Brief description of the drawings

The features and advantages pointed out in the foregoing, as well as other features and advantages, will be rendered even clearer by reading the following detailed description of exemplary and non-limitative embodiments thereof. For better intelligibility, the following description should be read making reference to the annexed drawings, in which:

Figs. 1 to 15 show, in schematic cross-sectional views, some steps of a manufacturing process according to an embodiment of the solution disclosed in this document for the fabrication of an electronic device, particularly a power MOSFET;

Fig. 16 is a diagram reporting measured thicknesses (in ordinate, nm) of graphite coating layers used in a laser annealing process for the electrical activation of the implanted dopants, when the coating layer is exposed to laser radiation, as a function of the energy density of the laser radiation (in abscissa, J/cm$^2$);

Fig. 17 is a diagram reporting the measured intensity of an intra-bandgap emission (in abscissa, arbitrary units a.u.) as a function of the wavelength (in ordinate, nm) of a laser annealed implanted semiconductor region vs. an implanted semiconductor region annealed in furnace;

Fig. 18 shows, in two TEM (Transmission Electron Microscopy) cross-sectional images, the difference in defectiveness between a device treated in accordance with the solution disclosed herein (image on the right) and a device subjected to furnace annealing for activating the implanted dopants;

Fig. 19 shows two SEM (Scanning Electron Microscopy) cross-sectional images of two material samples, both irradiated at 1000 shots/point 0.6 J/cm$^2$, one subjected to the coating assisted laser annealing process of the solution disclosed herein and the other one subjected to uncoated laser annealing;

Fig. 20 is a diagram plotting the heat conduction profile for a heat absorber coating layer of graphite;

Fig. 21 is a diagram showing the trend of temperatures as a function of time during a single laser shot, and

Fig. 22 is a schematic cross-sectional view of a Junction-Barrier controlled Schottky (JBS) diode, another electronic device whose fabrication can take advantage of the solution disclosed in this document.

Detailed description of exemplary embodiments

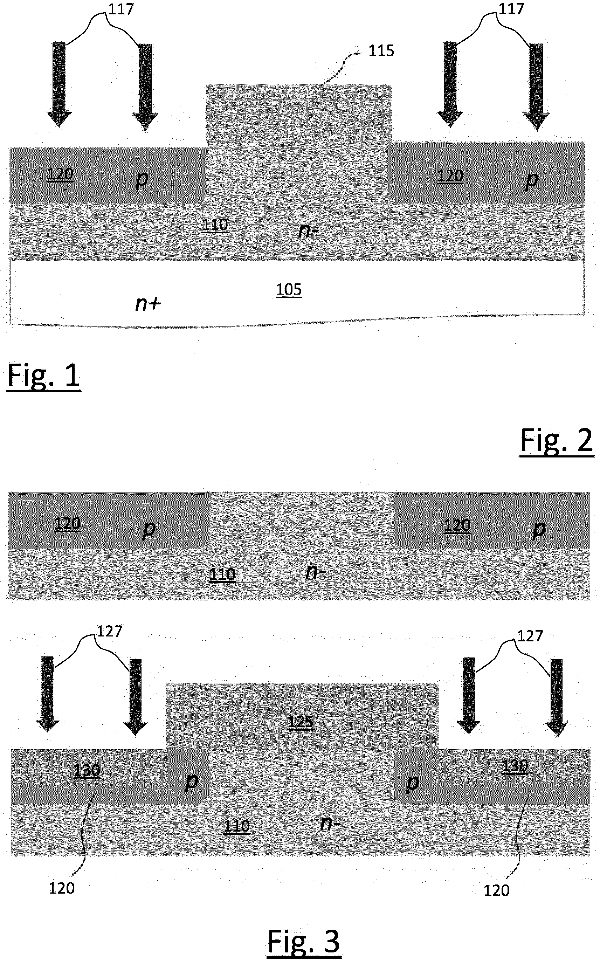

With reference to the annexed figures, Figs. 1 to 15 show, in schematic cross-sectional views, some steps of a manufacturing process according to an embodiment of the solution disclosed in this document for the fabrication of an electronic device, particularly a power MOSFET.

In Fig. 1 there is shown the structure of a power MOSFET under construction at a stage in which, on a semiconductor substrate **105,** particularly a wide-bandgap semiconductor substrate, even more particularly (but not limitatively) a SiC substrate heavily doped with dopant species of a first conductivity type (in the example, n type), an epitaxial layer of SiC **110** doped relatively lightly with n type dopants is provided, formed by means of epitaxial growth. By means of conventional photolithographic techniques, a photoresist mask **115** is provided on the top surface (i.e., the surface opposite to the substrate **105)** of the epitaxial layer **110,** by depositing a photoresist layer, exposing it to electromagnetic radiation through a mask, developing the exposed photoresist layer and selectively etching away the developed photoresist layer to leave the photoresist mask **115** in selected areas of interest.

Then, still referring to **Fig. 1,** dopant ions are introduced **117** into regions of the epitaxial layer **110** not covered by the photoresist mask **115,** to form so-called body regions **120** of the power MOSFET. The dopant ions that are introduced are of a second conductivity type, opposite to the first conductivity type (in the considered example, *p* type). The *p* type dopant ions are introduced by means of dopant implantation, particularly a multi-step dopant implantation. Typical implant doses are in the range $10^{12}$-$10^{13}$ cm$^{-2}$, to obtain dopant concentrations of the order of $10^{17}$ cm$^{-3}$.

After the dopant implantation step, the photoresist mask **115** is removed **(Fig. 2).**

Then **(Fig. 3),** by means of conventional photolithographic techniques, another photoresist mask **125** is provided on the top surface (i.e., the surface opposite to the substrate **105)** of the epitaxial layer **110,** by depositing a photoresist layer, exposing it to electromagnetic radiation through a mask, developing the exposed photoresist layer and selectively etching away the developed photoresist layer to leave the photoresist mask **125** in selected areas of interest. The photoresist mask **125** covers the epitaxial layer **100** in regions between the body regions **120** and extends, partly, over the edges of the body regions **120** themselves.

Still referring to **Fig. 3,** dopant ions are introduced **127** into regions of the epitaxial layer **110** not covered by the photoresist mask **125,** to form, inside the body regions **120,** source regions **130** of the power MOSFET. The dopant ions that are introduced are of the first conductivity type (in the considered example, *n* type). The *n* type dopant ions are introduced by means of dopant implantation, particularly a multi-step dopant implantation. Typical implant doses are in the range $10^{13}$-$10^{14}$ cm$^{-2}$, to obtain dopant concentrations of $10^{20}$ cm$^{-3}$.

As known in the art, after implantation the implanted dopant species are to be electrically activated by performing a thermal annealing process which, at the same time, recovers the defectiveness in the lattice of the material that received the implanted species.

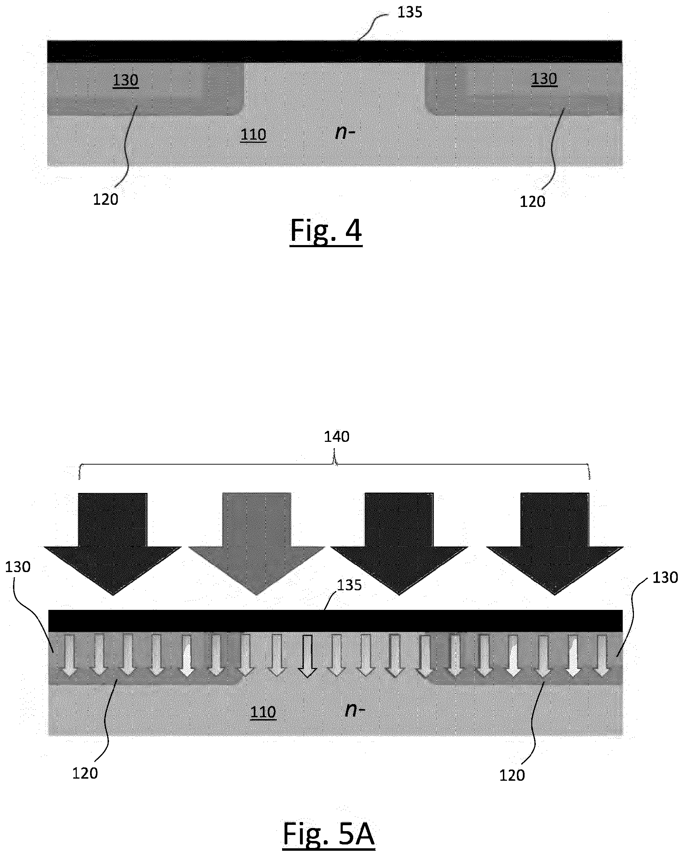

According to an embodiment of the solution disclosed in the present document, as shown in **Fig. 4** a coating layer **135** of a heat absorbing material is provided, e.g., by deposition, on the top surface of the structure (i.e., the surface opposite to the substrate **105,** not shown for the sake of simplicity in the figure). The heat absorbing coating layer **135** formed on the top surface of the structure has a suitable thickness, as discussed in greater detail later on. The heat absorbing coating layer **135** is made of a material having an optical extinction coefficient k equal to 0.2 or greater and a reflectance less than 5%. The heat absorbing coating layer **135** is for example a layer of amorphous carbon or graphite.

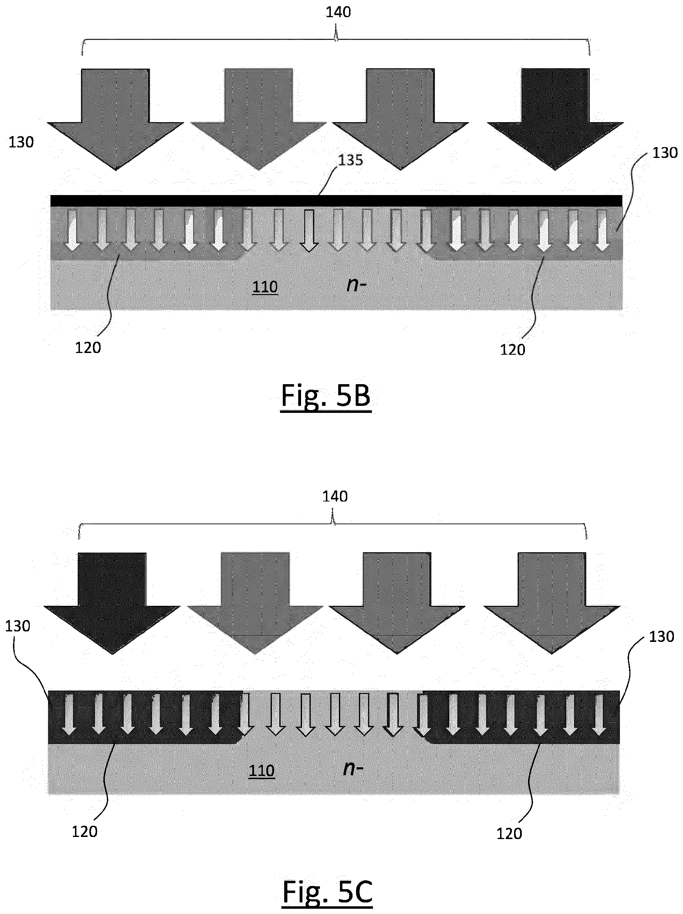

The structure, with the coating layer **135,** is then subjected to a laser thermal annealing process to electrically activate the implanted dopant species (namely, the *p* type dopants for the formation of the body regions **120** and the *n* type dopants for the formation of the source regions **130)** and to recover the defectiveness in the lattice of the material that received the implanted species. The structure is exposed to a suitable laser beam **140,** as schematized in **Figs. 5A, 5B** and **5C.** The energy (or energy density) of the laser radiation to be used is selected in dependence of the dose of implanted dopants. Higher doses of implanted dopants require higher laser energies (or energy densities) for electrical activation and defectiveness recovering. Since the dose of implanted dopants for the formation of the source regions **130** is relatively high (particularly, higher than the dose of implanted dopants for forming the body regions **120),** relatively high laser energies are needed to anneal the source regions implants.

According to the solution disclosed herein, the heat absorbing coating layer **135** of, e.g., amorphous carbon or graphite, is not protected from the exposure to the laser beam **140,** i.e., the coating layer **135** is exposed directly to the laser radiation **140** used for performing the thermal annealing process. In this way, during the exposure to the laser radiation the coating layer **135** undergoes a phenomenon of progressive erosion, possibly (depending on the initial thickness of the coating layer **135** and/or the power density of the laser radiation) till the complete ablation of the coating layer **135** from the top surface of the structure.

In greater detail, the Applicant has found that the erosion of the heat absorbing coating layer **135,** e.g., in amorphous carbon or graphite, during the laser thermal annealing process is not at all detrimental (contrary to the teachings of JP 2012069748), being instead advantageous under several respects for the results of the thermal annealing, as discussed here below.

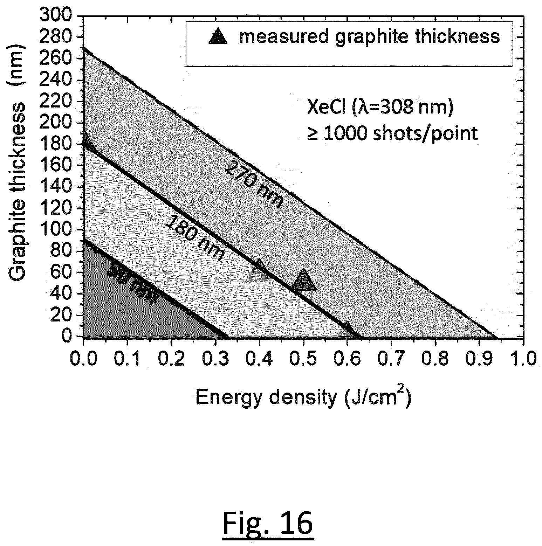

**Fig. 16** is a diagram reporting thicknesses (in ordinate, nm) of heat absorbing coating layers **135** in graphite of different initial thickness exposed to laser radiation, particularly a XeCl emitting laser radiation with wavelength of 308 nm and operated in pulsed mode, with an irradiation rate equal to or greater than 1000 shots/point. In the diagram of **Fig. 16,** the decrease in the thickness of the coating layers **135** with the increase of the energy density of the laser radiation (in abscissa, J/cm$^2$) is plotted. The triangles denote measured thicknesses (measurements made with Raman spectroscopy). The straight lines are extracted from experimental investigation (optical and SEM microscopy investigations), while the dashed line is obtained from a model found by the Applicant. Graphite coating layers **135** with three different initial thicknesses are considered: 90 nm, 180 nm and 270 nm. As shown in the diagram, irrespective of the initial thickness of the coating layer **135,** the thickness decreases (as a consequence of erosion due to exposure to the laser radiation) substantially linearly as the energy density of the laser radiation increases, till complete ablation (a condition that is reached for different laser energy densities depending on the starting coating layer thickness). In particular, a graphite coating layer **135** with an initial thickness of 90 nm layer ensures that the surface of the underlying substrate is kept intact (i.e., not directly exposed to laser radiation) up to a laser energy density of almost 0.4 J/cm$^2$. By starting with a graphite coating layer 135 180 nm thick, this condition is respected up to about 0.6 J/cm$^2$. A 270 nm thick graphite coating layer **135** is able to withstand radiation strengths up to 1 J/cm$^2$.

The erosion induced on the graphite coating layer **135** is mainly caused by exceeding phase transition temperature of 3800 °C.

Heat absorbing coating layers **135,** e.g., of amorphous carbon or graphite, exposed to laser radiation reach high temperatures, which involves heat transfer via thermal conduction onto the underlying SiC surface. This allows to avoid the increase in temperature due to high optical absorption in the SiC structure (which would induce strongly inhomogeneous annealings in thicknesses of a few tens of nanometers, and phase separation effects between Si and C at the SiC surface with consequent deterioration of the implantation regions).

The Applicant has found that, taking advantage of the progressive erosion of the heat absorbing coating layer **135** when exposed to the laser radiation **140** during the laser annealing process, the annealing process can be divided into two temporal phases. In a first annealing phase, the SiC structure (layer **110,** implanted regions **120, 130),** covered by the heat absorbing coating layer **135,** undergoes irradiation in conditions of low or no optical contact with the laser radiation **140.** In this first phase the main source of annealing is the heat transferred by the coating layer **135** to the SiC structure, particularly to the implanted regions **120** and **130.** During this first annealing phase, a first recovery of the SiC crystal from the damages caused by the implanted species is achieved. Thanks to this first recovery of the SiC crystal, the optical properties of the SiC structure are also recovered and therefore the SiC optical absorption coefficient is lowered.

The erosion of the heat absorbing coating layer **135** following the progress of the laser beam **140** irradiations per point leads and enhances an optical contact of the laser radiation **140** with the underling SiC structure. This optical contact is achieved in consequence to the erosion of the heat absorbing coating layer **135** and its thinning to, e.g., a 30 - 40 nm thick layer **(Figs. 5B** and **5C).** In this second annealing phase, both optical penetration of the laser radiation **140** transmitted through the remaining heat absorbing coating layer **135** and heat conduction from the heat absorbing coating layer **135,** contribute to the heating of the SiC structure.

This combination of effects induces a more effective annealing than in the phase of exclusive heat transmission (first phase of the annealing). During the heat transmission phase, essentially in the absence of optical penetration of the laser radiation **140** through the heat absorbing coating layer **135** till reaching the underlying SiC structure, there is a significant temperature gradient within the first layers of the SiC structure underlying the heat absorbing coating layer **135.** The annealing effect is experienced exclusively on superficial dopants implants. Instead, through the combined effect of optical penetration of the laser radiation and conduction heating, it is possible to perform an annealing induced by the transfer of heat from the heat absorbing coating layer **135,** as well as an annealing induced by the optical penetration of the laser radiation **140** into the implanted regions of the SiC structure. At this stage, the SiC structure exhibits an optical absorption coefficient intermediate between that of the SiC structure just after the implantation of dopants and that of a crystalline SiC structure and, in such a way, the SiC structure is able to tolerate higher energy densities as the initial heat absorbing coating layer **135** thickness increases.

The laser radiation **140,** featuring an optical penetration inside the SiC structure of about 1-2 $\mu$m, is able to carry out an annealing involving deeper SiC layers with respect to exclusive heat transmission from the heat absorbing coating layer **135** and, therefore, to carry out an annealing along deeper dopant implants. This is particularly useful when there are dopant implants whose extension in depth into the SiC structure exceeds about 500 nm.

Referring to the diagram of **Fig. 16,** relating to the exemplary case of a heat absorbing coating layer **135** made of graphite, it is possible to establish a relationship between the energy density of the laser radiation **140** and the starting thickness of the heat absorbing coating layer **135** that allows to irradiate regions of the SiC structure free from residual heat absorbing coating layer **135** (as a consequence of the erosion) and therefore directly exposed to laser irradiation, without involving any damage to the surface of the SiC implanted regions. Essentially, the energy density of the laser radiation is selected in dependence of the dose of implanted dopants in the semiconductor regions to be annealed. The initial thickness of the heat absorbing coating layer is selected based on the energy density of the laser radiation, such that the initial thickness is sufficient to prevent the laser radiation of the selected energy density from reaching a surface of the underlying implanted regions to be annealed. The exposure of the structure to the laser radiation lasts for a predetermined exposure time, during which the heat absorbing coating layer is progressively eroded by the laser radiation and progressively leaves at least part of the laser radiation to reach the surface of the implanted regions to be annealed.

The Applicant has derived from the experimental data a model that can be expressed by the following equation:

$$G_{th} = T_i - (287.7 \cdot {}^* E_d) \hspace{2cm} \text{(Eq. 1)}$$

where $G_{th}$ denotes the residual thickness of the graphite heat absorbing coating layer **135** after a treatment under laser radiation **140** at shots/point $\geq$ 1000, $T_i$ is the initial thickness of the graphite coating layer **135,** and $E_d$ denotes the energy density of the laser radiation **140.** In synthesis, the higher the implant dose in the SiC structure, the greater the thermal budget required for crystalline recovery and dopant activation, the higher the laser energy density required and, consequently, the thicker the graphite coating layer **135** formed on the implanted SiC structure surface. A relationship similar to that of Eq. 1 holds also for different materials used to form the heat absorbing coating layer.

The heat absorbing coating layer **135** can be a layer of crystalline graphite. Preferably, the heat absorbing coating layer **135** can be a layer of polycrystalline graphite, with the *c* crystal axis oriented orthogonally to the top surface of the structure (vertical axis in the figures). Polycrystalline graphite has a considerably higher thermal conductivity along the *c* crystal axis than crystalline graphite. This makes it favorable in the use of systems that provide the transmission of heat from a monochromatic radiative source.

Lasers with wavelengths above the SiC bandgap can be exploited, although the use of laser radiations with wavelengths below the bandgap is not excluded. In this latter case, although the optical absorption of the laser radiation **140** in the SiC structure would apparently be prevented, the process can rely on optical absorption due to ion implantation defects (dislocation loops, point defects such as $V_c$, $V_{Si}$, etc.) which introduce energy levels inside the SiC bandgap. Hence, these implantation defects form laser radiation absorber centers contributing to laser annealing.

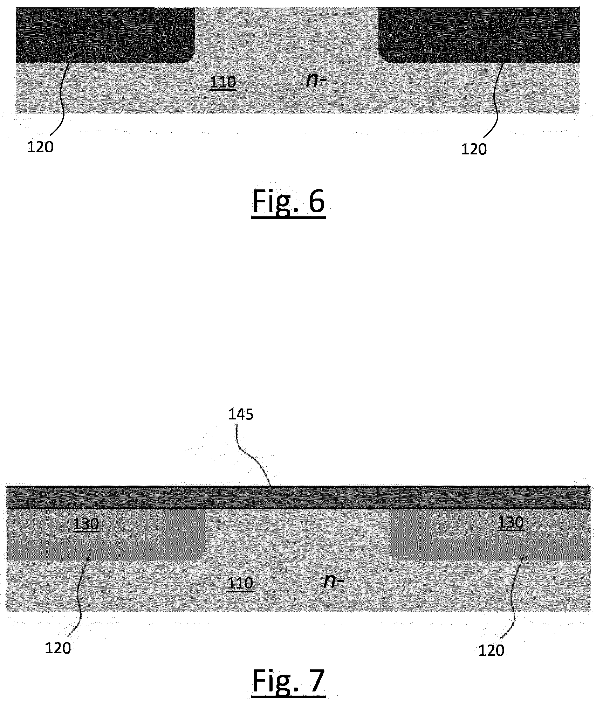

After the laser thermal annealing process, the manufacturing process continues. As shown in **Fig. 6,** the remaining (if any, i.e., if not completely ablated by erosion during irradiation by the laser radiation) heat absorbing coating layer **135** is removed, for example exploiting a $O_2$ plasma attack.

Then, a layer **145** of dielectric material, e.g., $SiO_2$, is formed on the top surface of the structure, as shown in **Fig. 7.** The layer of dielectric material **145** will form the gate oxide of the power MOSFET. The layer of dielectric material **145** can for example be formed by known deposition techniques, for example Chemical Vapor Deposition (CVD) techniques, particularly Plasma Enhanced CVD (PECVD).

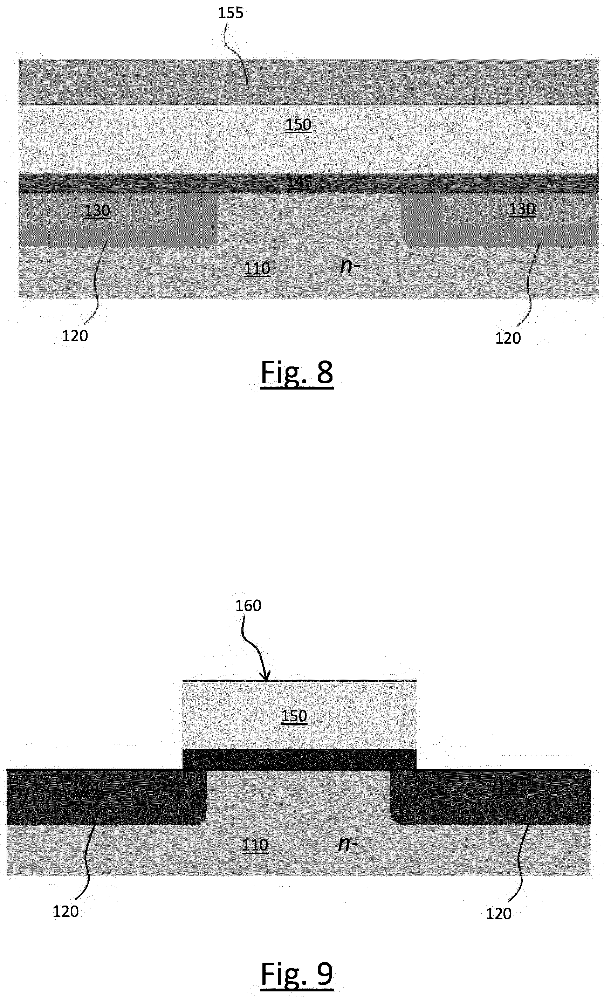

A layer **150** of electrically conductive material, for example polycrystalline silicon (polysilicon or poly-Si) or titanium tungsten (TiW) or a combination thereof, is formed on the layer of dielectric material **145,** as depicted in **Fig. 8.** The electrically conductive material layer **150** is for example formed by deposition. The electrically conductive material layer **150,** which can be relatively thin, e.g., of about 100 nm-500 nm, will form the gate electrode of the power MOSFET. Particularly, a combination of poly-Si and TiW with a layer **150** thickness in the range from about 100 nm to about 300 nm is preferred for 3C-SiC power MOSFETs, whereas a slightly thicker layer **150** of poly-Si, with a thickness up to about 500 nm, can be preferable for 4H-SiC power MOSFETs. Subsequent post-deposition activation annealing of the poly-Si (e.g., an RTA at 800 °C for about 1 minute, in argon atmosphere) is preferably performed in case of 3C-SiC power MOSFETs.

Also shown in **Fig. 8** is a mask layer of photoresist **155** that is provided, e.g., by deposition, on the top surface of the electrically conductive material layer **150.**

The photoresist layer **155** is then exposed to electromagnetic radiation through a photolithographic mask, then the exposed photoresist layer **155** is developed and selectively removed, being left only over those areas where the gate electrode of the power MOSFET will have to be defined. After selective removal by etching (e.g., dry etching) of the electrically conductive material layer **150** and of the layer of dielectric material **145,** the gate electrode **160** of the power MOSFET is defined, as shown in **Fig. 9.** The gate electrode **160** is formed over those regions of the epitaxial layer **110** that are surrounded by the body regions **120,** in slight overlap to the body regions **120.**

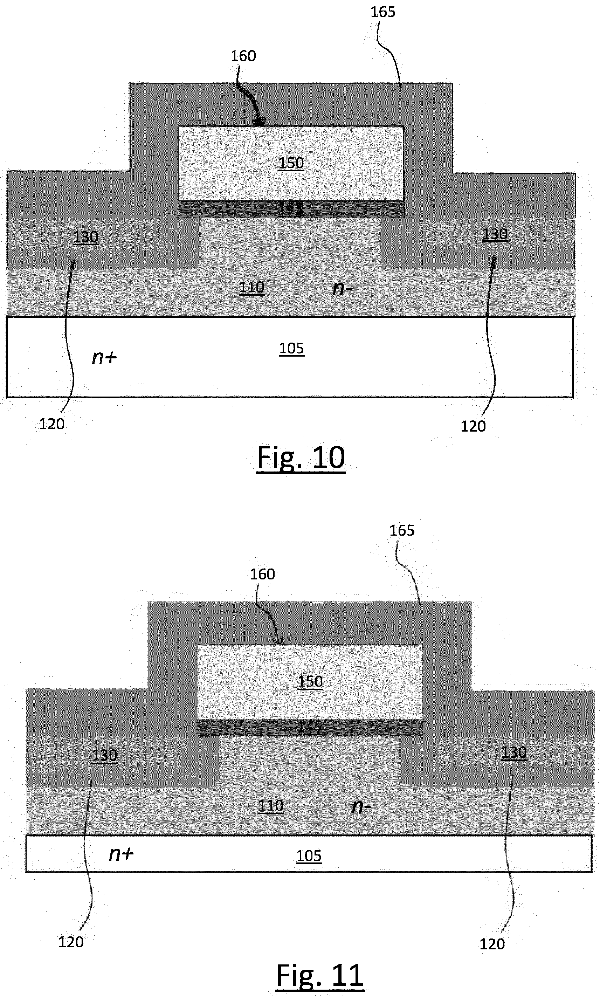

Passing to **Fig. 10,** a layer **165** of a passivation material is formed on the top surface of the structure. The passivation material layer **165** is for example a layer of oxide, particularly low temperature oxide (LTO) of the thickness of the order of 1 $\mu$m, and can be formed by deposition, e.g., Low Pressure CVD (LPCVD).

In order to form the drain electrical contact, the thickness of the substrate **105** is reduced from the backside (i.e., from the side opposite to the top surface of the structure), i.e., the substrate **105** is thinned, as shown in **Fig. 11.** The reduction in thickness of the substrate **105** from the backside is useful to reduce the drift layer resistance of the power MOSFET in the conduction state ($R_{on}$). The reduction in thickness of the substrate **105** from the backside can for example be accomplished by grinding.

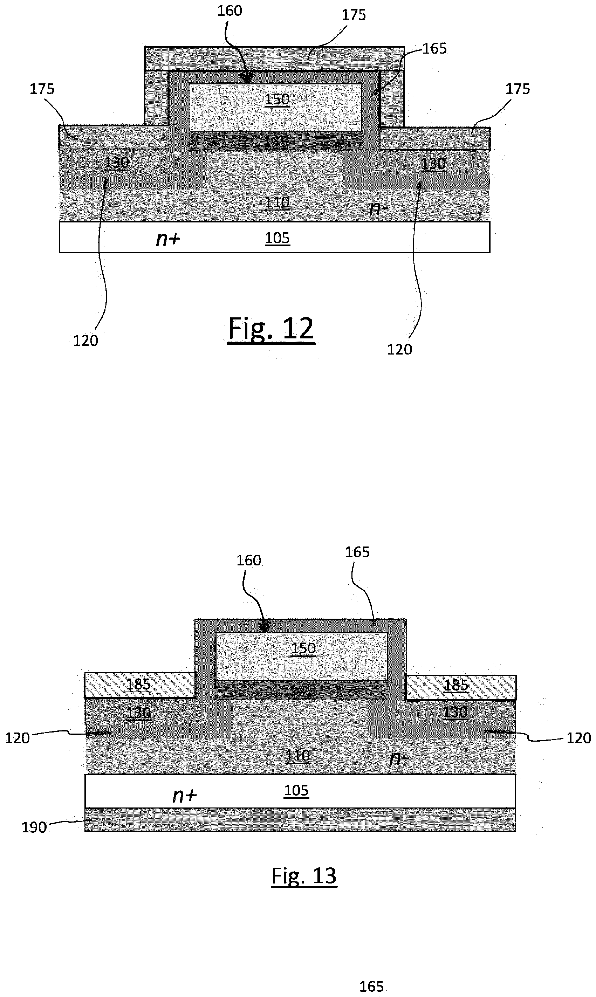

Moving to **Fig. 12,** the passivation material layer **165** is then selectively removed, being left just over and at the sides of the gate electrode **160** of the power MOSFET.

Electrical contacts to the source regions **130** are then formed. To form the electrical contacts to the source regions **130,** an ohmic contact precursor **175,** for example of nickel (Ni), is deposited on the top surface of the structure. A rapid thermal annealing process is then performed. The ohmic contact precursor **175** on the exposed surface of the source regions **130** (not covered by the remaining passivation material layer **165**) reacts with the SiC for the silicidation and formation of electrical contacts **185** to the source regions **130;** the nickel not reacted with SiC on the gate contact is removed by chemical etching **(Fig. 13).**

Then, the drain electrical contact has to be formed. As known, the drain contact in a power MOSFET is an electrical contact to the substrate **105.**

On the backside surface of the substrate **105** (after having reduced its thickness, as mentioned in the foregoing) a layer **190** of an ohmic contact precursor is deposited, for example nickel (Ni), as shown in **Fig. 13.** Other suitable precursors can be titanium (Ti) or tungsten (W) or nickel silicide (NiSi). A rapid thermal annealing is then performed, for the silicidation of the electrical contacts to the drain of the power MOSFET.

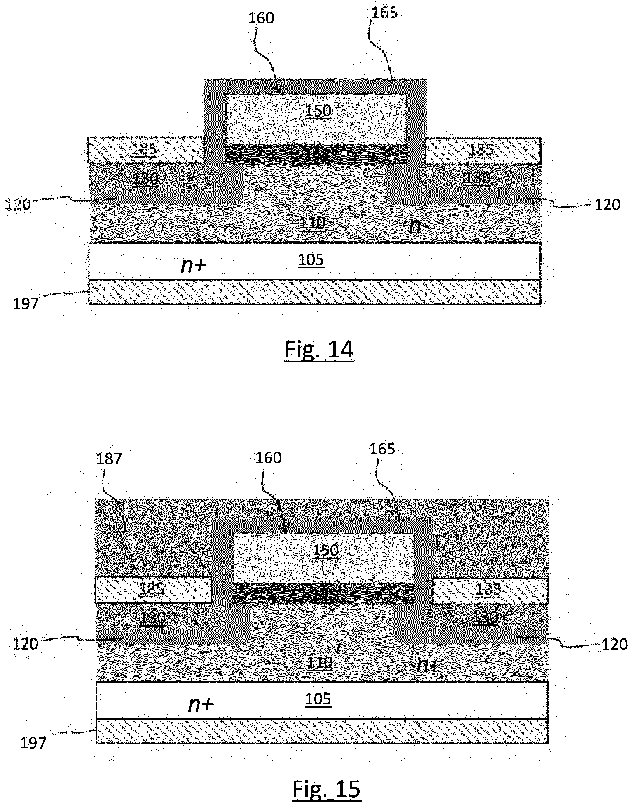

After the treatment, ohmic contact regions **197** are obtained, e.g., in nickel silicide (NiSi), as shown in **Fig. 14.**

As depicted in **Fig. 15,** an electrically conductive material layer **187** is then deposited on the top surface of the structure to form the source metal pad of the power MOSFET. For example, the electrically conductive material layer **187** can be a layer of titanium and/or aluminum (Ti/Al).

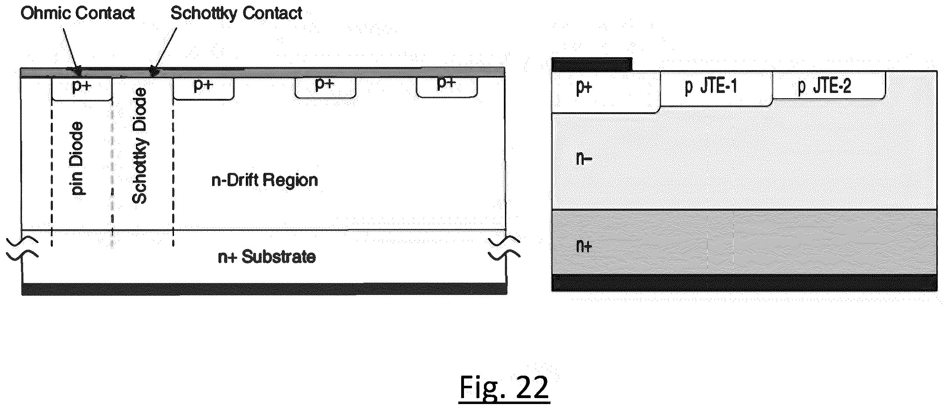

**Fig. 22** is a schematic cross-sectional view of a Junction-Barrier controlled Schottky (JBS) diode, another electronic device whose fabrication can take advantage of the solution disclosed in this document.

The JBS diode entails an architecture that combines the convenient features of *pin* and Schottky diodes. In particular, the JBS diode is designed to behave like a Schottky diode under forward bias (to minimize on-state and switching losses) and like *a pin* diode under reverse bias (to minimize off-state losses.

The device is manufactured on a substrate **2220** of a WBG semiconductor, e.g., SiC, doped relatively heavily with, e.g., donor ions to be a n+ substrate. On top of the substrate **2220,** a less heavily doped layer **2215** of the same conductivity type (n- layer) is formed. The n- layer **2215** will form a drift layer of the device.

A metal layer **2205** on top of the structure produces ohmic contacts to p+ implanted regions **2210** (anode areas) and Schottky contacts to the surface areas of the n- drift layer **2215,** resulting in a device that is made up of interdigitated Schottky and pin diodes coupled in parallel.

The p+ anode areas **2210** are separated sufficiently such that their depletion zones do not overlap under either zero or forward bias. This creates a conductive route among each Schottky contact and the n+ substrate through the n- drift layer **2215.**

In correspondence of the edges of the device a lightly doped p-type region **2225** called Junction Termination Edge (JTE) may be provided for. This acts as an edge termination to minimize field crowding along the edge of the Schottky junction, resulting in a device greater breakdown voltage. The JTE **2225** may consist of one or more, two in the shown example, concentric p-type rings **2230, 2235** with precisely regulated dopant concentrations encircling the main junction.

An important design criterion regards the overall dopant concentration per unit area in each p-type ring **2230, 2235** that should be low enough to let the ring go entirely depleted before avalanche breakdown occurs at the ring's edge. The breakdown voltage rises right before breakdown at the dosage where the ring gets depleted. However, the ring does not completely deplete with greater dosages, and breakdown starts at the ring's outer border. This is why this kind of dopants implant is usually made with doses ranging between $10^{12}$ cm$^{-2}$ and $10^{13}$ cm$^{-2}$, leading to concentrations of the order of $10^{16}$ - $10^{17}$ atoms/cm$^3$.

An implant dose (and resulting dopant concentration) in this range is, for the purposes of the solution here disclosed, referred to as a "light implant". An implant designed in this way causes minor damages to the SiC crystal. In this particular scenario, the damage deriving from the implant is small and induces a limited variation of optical and thermodynamic parameters of the SiC. In addition, at such low dopant concentration mild temperatures (T ranging between 1600 °C and 1800 °C) are sufficient to reach full dopant activation. Consequently, the recovery system can be also performed through lower laser energies and, consequently, the initial thickness of the coating heat absorbing material layer can be lower (90 nm or 180 nm following **Fig. 16** and from Eq. 1). As a result, the crystal can be further recovered both in the first implant layers and in the deeper layers.

The p+ implantation regions **2210,** having a concentration of the order of $10^{18}$ cm$^{-3}$ or greater, are referred to as "heavy implants", and they are characterized by higher levels of damage to the SiC crystal consequent to the implant. The high level of damages, due to the increased concentration of point defects, implies the involvement of higher laser energies for the annealing, and, consequently, to heat absorbing coating material layers of greater initial thickness. In this case, initial thicknesses of the order of 270 nm or greater are necessary to allow the application of the laser irradiation system according to Eq. 1.

Thus, similarly to the annealing of the source implant in power MOSFETs, when the electronic device to be manufactured has heavy dopant implants, graphite coating initial thicknesses of the order of 270 nm or greater should be used to allow effective irradiation.

Differently, when the electronic device to be manufactured includes light dopant implants (such as implants for forming breakdown control systems like the JTE or the Gloating Guard Ring - FGR), lower initial graphite thicknesses can be used.

The adoption of the solution disclosed in the present document can be detected in the fabricated electronic devices.

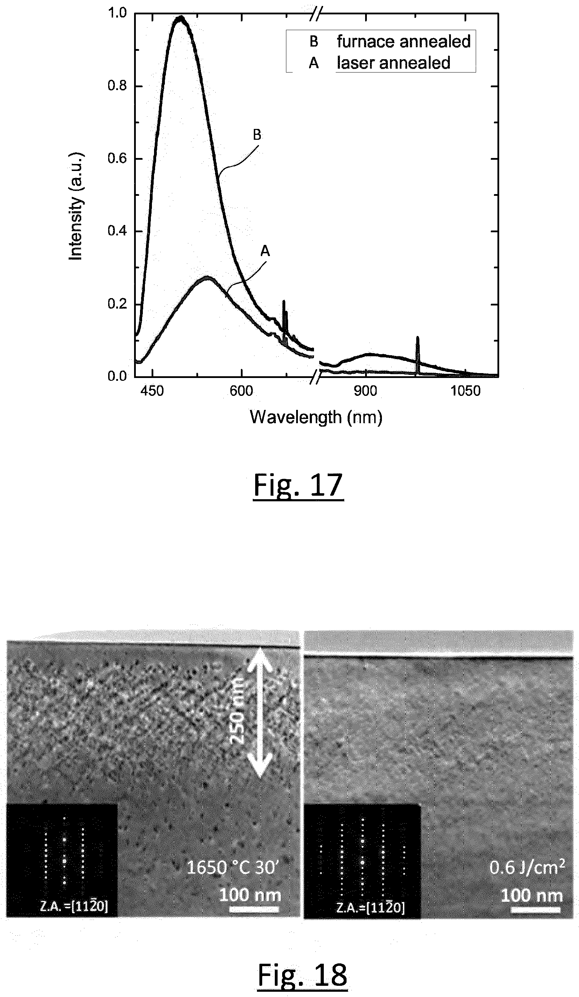

In particular, as shown in **Fig. 17,** which is a diagram reporting the measured intensity of an intra-bandgap emission (in abscissa, arbitrary units a.u.) as a function of the wavelength (in ordinate, nm) of a laser annealed SiC implanted region (curve **A)** vs. a SiC implanted region annealed in furnace (curve **B),** one way to detect that the electronic devices have been fabricated according to the solution herein disclosed is by observing that the characteristic room temperature intra-bandgap emission of the laser annealed implanted region is peaked at ~ 545 nm, while the sample which has been subjected to furnace annealing exhibits a peak at ~ 490 nm and a further emission between 850 nm and 1050 nm.

**Fig. 18** shows, in two TEM cross-sectional images, the difference in defectiveness between an electronic device fabricated in accordance with the solution disclosed herein (image on the right) and an electronic device subjected to furnace annealing for activating the implanted dopants (image on the left). It is readily seen that the laser annealing process returns a less extended defectiveness compared to the thermal (furnace) annealing sample presenting dislocation loops. Defect density is proportional to the implanted dopant concentration. These figures, in addition to demonstrating the advantages of the solution disclosed herein, also show that the fabricated electronic devices exhibit detectable characteristics.

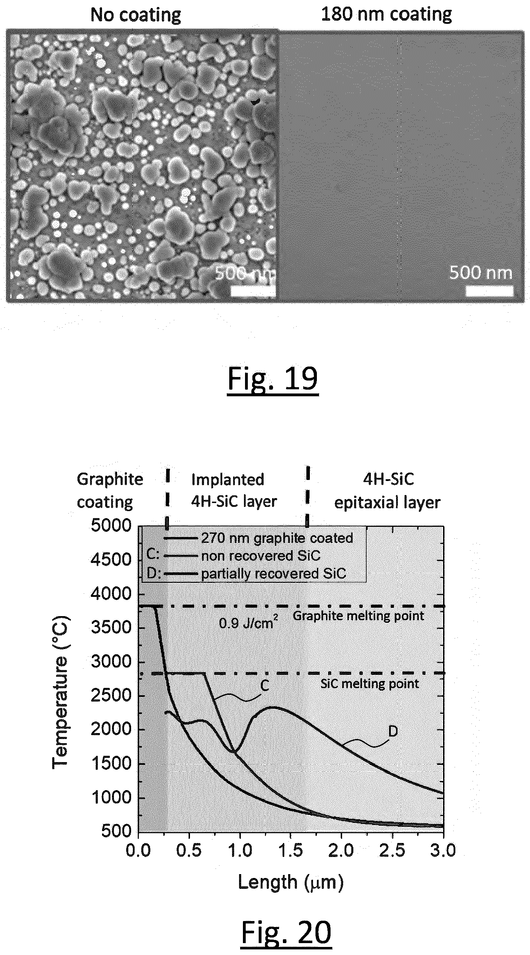

The solution disclosed herein, providing for a coating-assisted laser annealing treatment, assisted by a heat absorbing coating layer, for activating the implanted dopant species, is advantageous over laser annealing without coating. **Fig. 19** shows SEM images of two material samples, both irradiated at 1000 shots/point 0.6 J/cm$^2$. Unlike coating assisted laser annealing process (image on the right), an uncoated laser annealing (image on the left) presents implant surface erosion and aggregates surface (e.g., $SiO_2$).

To assess the effectiveness of the proposed solution and describe the feasibility of Eq. 1 (derived from experimental results, as depicted in **Fig. 16),** the irradiation of an implant with a thickness of 1.5 $\mu$m has been simulated on a 4H-SiC epitaxial layer with a 270 nm thick graphite coating superimposed. The implant dopant concentration is of the order of $10^{20}$cm$^{-3}$.

The simulation has been performed by irradiation with XeCl laser ($\lambda$ = 308 nm) with pulses lasting 30 ns. In order to suitably rise temperatures reached on irradiated sample and, simultaneously, increase the exposure time at temperatures suitable for activation (T > 1600 °C), the stage temperature (i.e., the temperature of the platform on which the samples under test have been placed during the laser irradiation phase) was set at T = 580 °C. The heat absorbing coating layer considered was polycrystalline graphite and therefore its thermal conductivity along the *c* axis was considered to be between 60 W/mK at the stage temperature and 30 W/mK close to its melting point. The simulation has been carried out using Fourier's laws on heat propagation and evaluating the evolution of the thermodynamic and optical parameters as the temperature varies. The first simulation step was carried out taking into account Eq. 1 and considering a graphite layer of 270 nm thickness in contact with the SiC implanted region. The thermodynamic parameters of graphite taken into consideration are those available for a highly absorbent material characterized by an optical absorption coefficient equal to approximately $2 \cdot 10^5$ cm$^{-1}$ which allows the optical absorption of laser radiation within a layer of 50 nm. **Fig. 20** displays the trend of temperatures (in ordinate, expressed in °C) measured at t = 30 ns as a function of sample depth (in abscissa, expressed in $\mu$m). Here the graphite heat absorbing coating layer reaches the melting temperature of 3800 °C in the first superficial layers thereof, contributing to the erosion phenomenon. The damage profile of the implant has been calculated using a SRIM (Stopping and Range of Ions in Matter) simulation. For implantation doses consistent with those commonly used for the formation of MOSFET source layers, a damage of the order of approximately 0.5 dpa (displacement per atom) is formed. For these levels of damage, the thermal conductivity of SiC lies in a range between 20 and 10 W/mK with the increase in temperature and it is, therefore, appropriate to assimilate the SiC implanted layer to a thermal insulator, contributing to the achievement of high temperatures in the early stages of annealing. The graphite heat absorbing coating layer is consequently particularly affected by the insulating behavior provided by the SiC implanted layer.

The initial stage of the annealing process has the role of recovery of the first damaged SiC layers, which contributes to the achievement of intermediate SiC thermal conductivities ranging between the typical values of the as-implanted (i.e., damaged) SiC layer and those of a fully crystalline one. During the laser shots, the SiC thermal conductivity raises to values between 90 W/mK and 30 W/mK with the increase in temperature and this contributes to the reduction of the temperature and to the sustainability of the process during the subsequent erosion of the graphite layer during subsequent laser shots. During this first phase of heat conduction established during the initial step of annealing, the heat conduction profile plotted in **Fig. 20** shows temperatures of the order of approximately 2700 °C, and in this phase the graphitic coating guarantees the integrity of the SiC surface from the desorption of SiC superficial atoms. It can be noted that the temperature tends to decrease with the sample depth, and temperatures below 1600 °C are already recorded after 450 nm depth in SiC implant. During this first step it is therefore possible to anneal the first portion of SiC included, at least, in the first 450 nm of implant from the SiC surface. To subject the whole implanted region to an effective annealing, a second annealing step follows. This second step comes into play thanks to the progressive erosion of the graphite heat absorbing coating layer, which allows the onset of optical contact between the laser radiation and the SiC layer. During the first irradiation phases described above, SiC is subjected to a crystalline recovery phase which allows to partially re-establish not only thermodynamic properties but also SiC absorption coefficient. This allows to proceed to a recovery of the crystal which passes from extremely high absorption coefficient $\alpha$ values (namely $\alpha$~$9 \cdot 10^4$ cm$^{-1}$ or greater) as previously described, to absorption coefficient values of the order of $\alpha$~$1 \cdot 10^4$cm$^{-1}$ leading to optical penetration lengths of the order of approximately 1 $\mu$m. The establishment of this recovery regime for SiC absorption coefficient gives rise to an annealing process capable of involving deeper layers of the sample. This process is consistent with the recovery process mediated by the thickness of the superimposed graphite coating layer. With the same energy, if the initial graphite layer had been thinner, the implanted SiC regions would have been subjected to temperatures beyond the SiC melting temperature, causing the deterioration of the SiC implant as consequence of the onset of phase separation processes as shown by curve **C** in **Fig. 20**.

The gradual recovery of the optical and thermodynamic parameters of the SiC therefore appears to be a preparatory step for the appropriate action of step 2 for the annealing process. The thermal profile involves a greater thickness of the system thanks to the lowering of the SiC absorption coefficient. Curve **D** shows how temperatures above 2000 °C are allowed along the entire SiC implanted layer, contributing to full involvement of the deeper implanted region. It is, therefore, evident that the presented technique permits to effectively activate deep implants that would not be activated by laser annealing performed with a fixed, not erodible heat absorbing coating or where, in any case, optical contact with the SiC layer is not allowed.

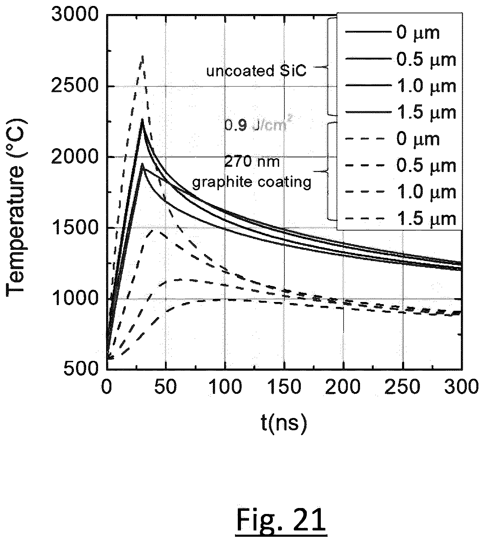

In light of what has been described, from the simulation results shown in **Fig. 21** the trend of temperatures (in ordinate, expressed in °C) as a function of time (in abscissa, expressed in ns) during the single laser shot can also be verified. The annealing ramp is very fast and is consistent with the duration of the laser shot. The temperature trend profile makes it possible to extrapolate the time over which the sample remains at temperatures above 1600 °C, which will be defined as the effective annealing time. Two cases can be considered: the case of irradiation on a 270 nm graphite coating layer and the case of irradiation of an uncoated SiC sample after coating absorber layer underwent erosion. In the first case the effective annealing time is around 48 ns on the surface and then clears after a few hundred nanometers. In the case of irradiation without heat absorbing layer coating, the effective annealing time is between 40 ns at 0.5 $\mu$m depth up to 87 ns at 1.5 $\mu$m. The complete thermalization of the samples is reached after 0.06 ms and widely allows to comfortably manage high frequencies of annealing, guaranteeing independent action of the laser shots and avoiding the superimposition of the thermal effects generated by contiguous laser shots that would not allow adequate control on the peak temperatures generated by the individual laser shots on the sample. Moreover, to let the SiC tolerate laser optical radiation contacts, the thickness of the graphite coating should be readjusted according to Eq. 1, so as to let the SiC tolerate the higher laser energies. The higher the degree of recovery of the crystal, the greater the tolerance to more intense laser energies.

The crystalline structure of graphite consists of $sp^2$ bonds. In the $sp^2$ bonds three of the four electrons are in trigonnally-coordinated hybridized orbitals which form $\sigma$ bonds ideally at 120° and the 4th electron is in the non-hybridized $p_z$. The Fresnel peaks of the electronic transitions appear near $\lambda = 85$ nm ($\sigma - \sigma^*$) and 250 nm ($\pi - \pi^*$) with reflection minima close to 50 nm and 160-190 nm corresponding to the absorption centers characterized by a high extinction coefficient. These peaks tend to shift towards higher wavelengths with increasing amorphization, presumably following the reduction of bond distances, as well as to widen due to larger distributions. Graphite, usually, has pure peaks at the $sp^2$ sites and therefore both Fresnel peaks appear narrow and thin following a thin distribution of bond distances. Amorphous carbon is defined by $sp^3$ hybridizations, but contains a number of $sp^2$ hybridizations and therefore is also defined by $\pi - \pi^*$ absorption peaks. The increase of the graphitic order from amorphous carbon allows the increase of the extinction coefficients. Amorphous carbon allows optical extinction coefficients of the order of k = 0.2 with the exception of the spectral region between 120 and 170 nm. This type of behavior allows to have optical absorption coefficients higher than $1.2 \cdot 10^{20}$ cm$^{-1}$ which involves full optical absorption in layers thinner than the minimum 90 nm layer defined by Eq. (1), guaranteeing the integrity of the underlying SiC layer in the first recovery step in the absence of optical contact.

As mentioned in the foregoing, in addition to amorphous carbon and graphite, there are other suitable materials for forming the heat absorbing coating layer **135**.

For example, a further category of materials of great interest due to their ability to efficiently absorb laser radiation, keep low losses thanks to low reflectance and efficiently transfer thermal energy to the underlying SiC structure includes Tantalum Carbide (TaC) and Hafnium Carbide (HfC). These materials possess the physical properties of ceramic such as high melting points, great hardness, chemical inertness and strength as well as the electronic properties of metals, such as a thermal conductivity which in these materials tends to increase with temperature. Furthermore, the listed materials are also characterized by the highest melting point of known materials and are particularly suitable for acting as a laser radiation absorber layer. For instance, TaC films are characterized by almost 50% reflectance, approaching 100% in the far infrared region. Reflectance, however, deeply decreases approaching the near infrared spectral region, reaching almost zero reflectivity between $\lambda = 800$ and 900 nm. Below this wavelength the reflectance rises, reaching values of the order of 18% at 300 nm and 25% around 200 nm, definitely decreasing at further lower wavelengths. The high absorption coefficient values allow a strong absorption in the UV, visible and infrared region. Other materials that can be used as heat absorbing coatings are Zirconium Carbide (ZrC) and Hafnium Carbide (HfC) which share low reflectivity in the UV and visible regions together with high absorption coefficients, as well as melting temperatures above 3500 °C. Materials with similar characteristics, but with melting temperatures below this threshold such as Tantalum diboride (TaB$_2$), Zirconium diboride (ZrB$_2$), Hafnium diboride (HfB$_2$) could also be used as sacrificial material, however they will tend to have higher erosion rates due to the lower sustainability of high thermal gradients between the surface and the interface with SiC.

The laser annealing system proposed is susceptible to implant doses within the semiconductor and consequently to the dopant concentration incorporated within the crystalline matrix. Crystal damage will, therefore, be effectively detectable as a function of the implanted dopant concentration.

Depending on the damage induced by the implant, the annealing system may be modeled employing various configurations.

**Claims**

1.  A method of fabricating an electronic device comprising:

    - providing a layer of a wide-bandgap semiconductor material **(110; 2215)** having a conductivity type;
    - implanting dopant species in selected regions **(120, 130; 2210, 2230, 2235)** of said layer of a wide-bandgap semiconductor material **(110; 2215)** to form implanted regions of said layer of a wide-bandgap semiconductor material, said implanted regions having an altered conductivity type with respect to the conductivity type of the layer of a wide-bandgap semiconductor material, and
    - annealing the implanted regions of the layer of a wide-bandgap semiconductor material,

    wherein said annealing comprises:

    - coating said implanted regions to be annealed with a heat absorbing material layer **(135),** the heat absorbing material layer having an initial thickness, the material of the heat absorbing material layer having an optical extinction coefficient k equal to 0.2 or greater and a reflectance less than 5%, and
    - exposing the heat absorbing material layer to a laser radiation **(140)** having an energy density, to anneal the selected regions of the layer of a wide-bandgap semiconductor material,

    and wherein:

    - the energy density of the laser radiation is selected in dependence of a dose of dopants of said implanted regions;
    - the initial thickness of the heat absorbing material layer is selected based on the energy density of the laser radiation so as to be sufficient to prevent the laser radiation to reach a surface of the underlying implanted regions to be annealed, and
    - said exposing the heat absorbing material layer to a laser radiation lasts for an exposure time and, during said exposure time, the heat absorbing material layer is subjected to erosion, so that during the exposure time the erosion of the heat absorbing material layer progressively allows at least part of the laser radiation to reach the surface of the underlying implanted regions to be annealed.

2.  The method of claim 1, wherein the heat absorbing material layer is a layer of a material selected from:

    amorphous carbon;
    graphite;
    Tantalum Carbide, TaC;
    Hafnium Carbide, HfC;
    Tantalum diboride, $TaB_2$;
    Zirconium Carbide, ZrC;
    Zirconium diboride, $ZrB_2$;
    Hafnium diboride, $HfB_2$.

3.  The method of claim 2, wherein the heat absorbing material layer is a layer of polycrystalline graphite.

4.  The method of any of the preceding claims, wherein the heat absorbing material layer has a melting temperature higher than a melting temperature of the wide-bandgap semiconductor material.

5.  The method of any one of the preceding claims, wherein the wide-bandgap semiconductor material is SiC.

6.  The method of any one of the preceding claims, wherein said laser radiation is a radiation emitted by an XeCl laser source at shots/point $\geq$ 1000, said heat absorbing material layer is a layer of graphite, and wherein a residual thickness $G_{th}$ of the heat absorbing material layer depends on said initial thickness, $T_i$, and on said energy density of the laser radiation, $E_d$, according to the equation:

$$G_{th} = T_i - (287.7 \cdot {}^* E_d)$$

7. The method of any of the preceding claims, wherein the laser energy of the laser radiation is either greater than a bandgap of the wide-bandgap semiconductor material, e.g., ultraviolet, or lower than/equal to the bandgap of the wide-bandgap semiconductor material, e.g., visible and infrared.

8. A method according to claim 6, wherein for the annealing of a heavy implant of the order of $10^{18}$ cm$^{-3}$ or greater said initial thickness of the heat absorbing material layer is of about 270 nm or greater, while for the annealing of a light implant with a dopant concentration up to an order of $10^{17}$ cm$^{-3}$ said heat absorbing material layer is less than 270 nm.

9. A semiconductor device comprising a layer of a wide-bandgap semiconductor material **(110; 2215)** with selected regions thereof **(120, 130; 2210, 2230, 2235)** doped with dopants altering a conductivity type of the layer of a wide-bandgap semiconductor material, wherein the semiconductor device is fabricated by means of a method according to any one of the preceding claims.

10. The semiconductor device of claim 9, wherein the wide-bandgap semiconductor material is SiC.

11. The semiconductor device of claim 9 or 10, wherein the regions **(120, 130)** of the layer of a wide-bandgap semiconductor material **(110)** doped with dopants have small depths as well as depths greater than 1$\mu$m.

12. The semiconductor device of claim 9 or 10 or 11, wherein the semiconductor device comprises a MOSFET, particularly a power MOSFET, and wherein the regions **(120, 130)** of the layer of a wide-bandgap semiconductor material **(110)** doped with dopants include body regions and source regions of the power MOSFET.

13. The semiconductor device of any one of claims 9 to 11, wherein the semiconductor device comprises a Junction-Barrier controlled Schottky diode and wherein the regions **(2210, 2230, 2235)** of the layer of a wide-bandgap semiconductor material **(2215)** doped with dopants include anode regions **(2210)** and Junction Termination Edge regions **(2230, 2235)** of the Junction-Barrier controlled Schottky diode.

**Patentansprüche**

1. Verfahren zur Herstellung eines elektronischen Geräts, umfassend:

   - Bereitstellen einer Schicht aus einem Halbleitermaterial mit großer Bandlücke **(110; 2215)** eines Leitfähigkeitstyps;
   - Implantieren von Dotierstoffarten in ausgewählte Bereiche **(120, 130; 2210, 2230, 2235)** der Schicht aus einem Halbleitermaterial mit großer Bandlücke **(110; 2215),** um implantierte Bereiche der Schicht aus einem Halbleitermaterial mit großer Bandlücke zu bilden, wobei die implantierten Bereiche einen anderen Leitfähigkeitstyp in Bezug auf den Leitfähigkeitstyp der Schicht aus einem Halbleitermaterial mit großer Bandlücke aufweisen, und
   - Tempern der implantierten Bereiche der Schicht aus einem Halbleitermaterial mit großer Bandlücke,
   worin

   das Tempern umfasst:

   - Beschichten der zu tempernden implantierten Bereiche mit einer Schicht aus wärmeabsorbierendem Material **(135),** wobei die Schicht aus wärmeabsorbierendem Material eine Anfangsdicke aufweist, das Material der Schicht aus wärmeabsorbierendem Material einen optischen Extinktionskoeffizienten k von 0,2 oder mehr und einen Reflexionsgrad von weniger als 5% aufweist, und
   - Aussetzen der Schicht aus wärmeabsorbierendem Material einer Laserstrahlung **(140)** mit einer Energiedichte, um die ausgewählten Bereiche der Schicht aus einem Halbleitermaterial mit großer Bandlücke zu tempern,

   und worin:

   - die Energiedichte der Laserstrahlung wird in Abhängigkeit von der Dotierstoffdosis der implantierten Bereiche gewählt;
- die anfängliche Dicke der wärmeabsorbierenden Materialschicht wird auf der Grundlage der Energiedichte der Laserstrahlung so gewählt, dass sie ausreicht, um zu verhindern, dass die Laserstrahlung eine Oberfläche der darunter liegenden zu glühenden implantierten Bereiche erreicht, und
- das Aussetzen der Schicht aus wärmeabsorbierendem Material einer Laserstrahlung dauert eine Belichtungszeit an und während dieser Belichtungszeit wird die Schicht aus wärmeabsorbierendem Material einer Erosion unterzogen, so dass während der Belichtungszeit die Erosion der Schicht aus wärmeabsorbierendem Material es zumindest einem Teil der Laserstrahlung ermöglicht, die Oberfläche der darunter liegenden implantierten Bereiche zu erreichen, um getempert zu werden.

2. Verfahren nach Anspruch 1, wobei die wärmeabsorbierende Materialschicht eine Schicht aus einem Material ist, das ausgewählt ist aus:

amorph Kohlenstoff;
Graphit;
Tantal Karbid, TaC;
Hafniumcarbid, HfC;
Tantal Diborid, $TaB_2$;
Zirkoniumcarbid, ZrC;
Zirkoniumdiborid, $ZrB_2$;
Hafniumdiborid, $HfB_2$.

3. Verfahren nach Anspruch 2, wobei die wärmeabsorbierende Materialschicht eine Schicht aus polykristallinem Graphit ist.

4. Das Verfahren nach einem der vorhergehenden Ansprüche, wobei die Schicht aus wärmeabsorbierendem Material eine Schmelztemperatur aufweist, die höher ist als die Schmelztemperatur des Halbleitermaterials mit großer Bandlücke.

5. Das Verfahren nach einem der vorhergehenden Ansprüche, wobei das Halbleitermaterial mit großer Bandlücke SiC ist.

6. Das Verfahren nach einem der vorhergehenden Ansprüche, wobei die Laserstrahlung eine von einer XeCl- Laserquelle mit Schüssen/Punkt ≥ 1000 emittierte Strahlung ist, die Schicht aus wärmeabsorbierendem Material eine Schicht aus Graphit ist und eine Restdicke $G_{th}$ der Schicht aus wärmeabsorbierendem Material von der Anfangsdicke $T_i$ und der Energiedichte der Laserstrahlung $E_d$ gemäß der folgenden Gleichung abhängt:

$$G_{th} = T_i - (287{,}7 \cdot {}^* E_d)$$

7. Das Verfahren nach einem der vorhergehenden Ansprüche, wobei die Laserenergie der Laserstrahlung entweder größer als eine Bandlücke des Halbleitermaterials mit großer Bandlücke, z. B. Ultraviolett, oder kleiner als/gleich der Bandlücke des Halbleitermaterials mit großer Bandlücke, z. B. sichtbar oder infrarot, ist.

8. Verfahren nach Anspruch 6, wobei beim Ausheilen eines schweren Implantats in der Größenordnung von $10^{18}$ cm$^{-3}$ oder mehr die anfängliche Dicke der wärmeabsorbierenden Materialschicht etwa 270 nm oder mehr beträgt, während beim Ausheilen eines leichten Implantats mit einer Dotierstoffkonzentration bis zu einer Größenordnung von $10^{17}$ cm$^{-3}$ die Dicke der wärmeabsorbierenden Materialschicht weniger als 270 nm beträgt.

9. Ein Halbleiterbauelement, das eine Schicht aus einem Halbleitermaterial mit großer Bandlücke **(110; 2215)** umfasst, wobei ausgewählte Bereiche **(120, 130; 2210, 2230, 2235)** davon mit Dotierstoffen dotiert sind, die den Leitfähigkeitstyp der Schicht aus einem Halbleitermaterial mit großer Bandlücke verändern, wobei das Halbleiterbauelement mittels eines Verfahrens gemäß einem der vorhergehenden Ansprüche hergestellt ist.

10. Halbleiterbauelement nach Anspruch 9, wobei das Halbleitermaterial mit großer Bandlücke SiC ist.

11. Halbleiterbauelement nach Anspruch 9 oder 10, wobei die Bereiche **(120, 130)** der mit Dotierstoffen dotierten Schicht aus einem Halbleitermaterial mit großer Bandlücke **(110)** sowohl geringe Tiefen als auch Tiefen größer als 1 $\mu$m

aufweisen.

**12.** Halbleiterbauelement nach Anspruch 9 oder 10 oder 11, wobei das Halbleiterbauelement einen MOSFET, insbesondere einen Leistungs-MOSFET, umfasst und wobei die Bereiche **(120, 130)** der mit Dotierstoffen dotierten Schicht aus einem Halbleitermaterial mit großer Bandlücke **(110)** Body-Bereiche und Source-Bereiche des Leistungs-MOSFET umfassen.

**13.** Das Halbleiterbauelement nach einem der Ansprüche 9 bis 11, wobei das Halbleiterbauelement eine Junction-Barrier-gesteuerte Schottky-Diode umfasst und wobei die Bereiche **(2210, 2230, 2235)** der mit Dotierstoffen dotierten Schicht aus einem Halbleitermaterial mit großer Bandlücke **(2215)** Anodenbereiche **(2210)** und Junction-Termination-Randbereiche **(2230, 2235)** der Junction-Barrier-gesteuerten Schottky-Diode umfassen.

**Revendications**

**1.** Procédé de fabrication d'un dispositif électronique comprenant:

- fournir une couche d'un matériau semi-conducteur à large bande interdite **(110; 2215)** ayant un type de conductivité;
- implanter des espèces dopantes dans des régions sélectionnées **(120, 130; 2210, 2230, 2235)** de ladite couche de matériau semi-conducteur à large bande interdite **(110; 2215)** pour former des régions implantées de ladite couche de matériau semi-conducteur à large bande interdite, lesdites régions implantées ayant un type de conductivité modifié par rapport au type de conductivité de la couche de matériau semi-conducteur à large bande interdite, et
- recuire les régions implantées de la couche d'un matériau semi-conducteur à large bande interdite, **caractérisé en ce que**

ledit recuire comprend:

- revêtir lesdites régions implantées à recuire d'une couche de matériau absorbant la chaleur **(135),** la couche de matériau absorbant la chaleur ayant une épaisseur initiale, le matériau de la couche de matériau absorbant la chaleur ayant un coefficient d'extinction optique k égal ou supérieur à 0,2 et une réflectance inférieure à 5 %, et
- exposer la couche de matériau absorbant la chaleur à un rayonnement laser **(140)** ayant une densité d'énergie, pour recuire les régions sélectionnées de la couche d'un matériau semi-conducteur à large bande interdite,

et où:

- la densité énergétique du rayonnement laser est choisie en fonction d'une dose de dopants desdites régions implantées ;
- l'épaisseur initiale de la couche de matériau absorbant la chaleur est choisie en fonction de la densité énergétique du rayonnement laser de manière à être suffisante pour empêcher le rayonnement laser d'atteindre une surface des régions implantées sous-jacentes à recuit, et
- ladite exposition de la couche de matériau absorbant la chaleur à un rayonnement laser dure un temps d'exposition et, pendant ledit temps d'exposition, la couche de matériau absorbant la chaleur est soumise à une érosion, de sorte que pendant le temps d'exposition l'érosion de la couche de matériau absorbant la chaleur permet progressivement à au moins une partie du rayonnement laser d'atteindre la surface des régions implantées sous-jacentes à recuit.

**2.** Procédé selon la revendication 1, dans lequel la couche de matériau absorbant la chaleur est une couche d'un matériau choisi parmi:

amorphe carbone ;
graphite;
Tantale Carbure, TaC;
Carbure d'hafnium, HfC;
Tantale diborure, $TaB_2$;
Carbure de zirconium, ZrC;
Diborure de zirconium, $ZrB_2$;

Diborure d'hafnium, HfB$_2$.

3. Procédé selon la revendication 2, dans lequel la couche de matériau absorbant la chaleur est une couche de graphite polycristallin.

4. Procédé selon l'une quelconque des revendications précédentes, dans lequel la couche de matériau absorbant la chaleur a une température de fusion supérieure à une température de fusion du matériau semi-conducteur à large bande interdite.

5. Procédé selon l'une quelconque des revendications précédentes, dans lequel le matériau semi-conducteur à large bande interdite est du SiC.

6. Procédé selon l'une quelconque des revendications précédentes, dans lequel ledit rayonnement laser est un rayonnement émis par une source laser XeCl à un nombre de coups/point $\geq$ 1000, ladite couche de matériau absorbant la chaleur est une couche de graphite, et dans lequel l'épaisseur résiduelle $G_{th}$ de la couche de matériau absorbant la chaleur dépend de l'épaisseur initiale $T_i$ et de la densité d'énergie du rayonnement laser $E_d$ , selon l'équation suivante:

$$G_{th} = T_i - (287{,}7 \cdot {}^* E_d)$$

7. Procédé selon l'une quelconque des revendications précédentes, dans lequel l'énergie laser du rayonnement laser est soit supérieure à une bande interdite du matériau semi-conducteur à large bande interdite, par exemple ultraviolette, soit inférieure/égale à la bande interdite du matériau semi-conducteur à large bande interdite, par exemple visible et infrarouge.

8. Procédé selon la revendication 6, dans lequel, pour le recuit d'un implant lourd de l'ordre de 10$^{18}$ cm$^{-3}$ ou plus, ladite épaisseur initiale de la couche de matériau absorbant la chaleur est d'environ 270 nm ou plus, tandis que pour le recuit d'un implant léger avec une concentration en dopant jusqu'à un ordre de 10$^{17}$ cm$^{-3}$, ladite couche de matériau absorbant la chaleur est inférieure à 270 nm.

9. Dispositif semi-conducteur comprenant une couche d'un matériau semi-conducteur à large bande interdite **(110; 2215)** avec des régions sélectionnées de celle-ci **(120, 130; 2210, 2230, 2235)** dopées avec des dopants modifiant un type de conductivité de la couche d'un matériau semi-conducteur à large bande interdite, dans lequel le dispositif semi-conducteur est fabriqué au moyen d'un procédé selon l'une quelconque des revendications précédentes.

10. Dispositif semi-conducteur selon la revendication 9, dans lequel le matériau semi-conducteur à large bande interdite est du SiC.

11. Dispositif semi-conducteur selon la revendication 9 ou 10, dans lequel les régions **(120, 130)** de la couche d'un matériau semi-conducteur à large bande interdite **(110)** dopé avec des dopants ont de faibles profondeurs ainsi que des profondeurs supérieures à 1 $\mu$m.

12. Dispositif semi-conducteur selon la revendication 9 ou 10 ou 11, dans lequel le dispositif semi-conducteur comprend un MOSFET, en particulier un MOSFET de puissance, et dans lequel les régions **(120, 130)** de la couche d'un matériau semi-conducteur à large bande interdite **(110)** dopé avec des dopants comprennent des régions de corps et des régions de source du MOSFET de puissance.

13. Dispositif semi-conducteur selon l'une quelconque des revendications 9 à 11, dans lequel le dispositif semi-conducteur comprend une diode Schottky contrôlée par barrière de jonction et dans lequel les régions **(2210, 2230, 2235)** de la couche d'un matériau semi-conducteur à large bande interdite **(2215)** dopée avec des dopants comprennent des régions d'anode **(2210)** et des régions de bord de terminaison de jonction **(2230, 2235)** de la diode Schottky contrôlée par barrière de jonction.

117

115

120 p

120 p

110 n-

105 n+

**Fig. 1**

**Fig. 2**

120 p

120 p

110 n-

127

127

125

130 p

p 130

110 n-

120

120

**Fig. 3**

**Fig. 4**

**Fig. 5A**

## Fig. 5B

## Fig. 5C

110    *n-*

120                    120

## Fig. 6

145

130                    130

110    *n-*

120                    120

## Fig. 7

**Fig. 8**

**Fig. 9**

Fig. 10

Fig. 11

160    175
    165

175    175

150

145

130    130

110    n-

n+    105

120    120

## Fig. 12

160    165

150

185    145    185

130    130

120    120

110    n-

n+    105

190

## Fig. 13

165

160   165

185   150

145   185

130   130

120   120

110   n-

n+   105

197

Fig. 14

187   160   165

185   150

145   185

130   130

120   120

110   n-

n+   105

197

Fig. 15

**Fig. 16**

Fig. 17

Fig. 18

**No coating**

**180 nm coating**

500 nm

500 nm

## Fig. 19

## Fig. 20

Fig. 21

Ohmic Contact

pin Diode

p+

Schottky Diode

Schottky Contact

p+

n-Drift Region

p+

n+ Substrate

p+

**Fig. 22**

n+

n-

p+

p JTE-1

p JTE-2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2019341261 A1

- JP 2012069748 B